# EUROPÄISCHE PATENTSCHRIFT

(11) **EP 1 159 860 B1**
(45) Veröffentlichungstag und Bekanntmachung des Hinweises auf die Patenterteilung: **17.11.2004**
(21) Anmeldenummer: 00912376.1
(22) Anmeldetag: 15.02.2000
(51) Int. Cl.: H05K 13/04

(54) **ZUFÜHREINRICHTUNG FÜR GEGURTETE SMD-BAUELEMENTE**
FEEDER FOR TAPED SMD COMPONENTS
DISPOSITIF D'ALIMENTATION POUR COMPOSANTS MONTES EN SURFACE SUR BANDE

(30) Priorität: 15.02.1999 DE 19906222
(43) Veröffentlichungstag der Anmeldung: 05.12.2001
(73) Patentinhaber: Siemens Aktiengesellschaft, 80333 München (DE)
(72) Erfinder: SCHULZ, Ralf, D-81241 München (DE); GOLLER, Hugo, D-80797 München (DE)
(74) Vertreter: Berg, Peter, Dipl.-Ing.
(86) Internationale Anmeldenummer: PCT/DE2000/000434
(87) Internationale Veröffentlichungsnummer: WO 2000/049848

(56) Entgegenhaltungen:
- EP-A- 0 589 275
- DE-A- 3 736 530

## Beschreibung

Bei der automatischen Bestückung von Leiterplatten mit oberflächenmontierbaren Bauelementen, den sog. SMD-Bauelementen, erfolgt die Bereitstellung der Bauelemente über verschiedene Arten von Zuführeinrichtungen, wobei hier jedoch der Bereitstellung von gegurteten Bauelementen eine besondere Bedeutung zukommt. Die Anlieferform im Gurt (vgl. DIN IEC 286, Sept. 1987) ist besonders automatisierungsfreundlich, da die Bauelemente bereits vereinzelt sind und die Verpackung im Gurt weitgehende Sicherheit gegen Vertauschung gewährleistet. In den einzelnen Zuführeinrichtungen für gegurtete Bauelemente werden die Gurte mit den Bauelementen von einer Gurtspule abgespult und dann einer Entnahmeposition für die Bauelemente zugeführt. In der Entnahmeposition werden die Bauelemente dann mit der Saugpipette eines Bestückkopfes aufgenommen und in der vorgegebenen Bestückposition einer Leiterplatte abgesetzt (vgl. EP-A-0 013 977 und EP-A-0 016 368). Um die Bauelemente in der richtigen Entnahmeposition bereitzustellen, wird der Gurt mit Hilfe eines Transportrades angetrieben, dessen Transportstifte in die Transportlöcher des Gurtes eingreifen. Da die SMD-Bauelemente immer kleiner gebaut werden und außerdem möglichst hohe Bestückleistungen angestrebt werden, werden an Zuführeinrichtungen für gegurtete SMD-Bauelemente folgende Hauptforderungen gestellt:
- möglichst hohe Positioniergenauigkeit
- möglichst kurze Transportzeiten
- Gurttransporte wahlweise für eine 4 mm-Teilung und eine 2mm-Teilung der Bauelementefächer des Gurtes.

Durch die EP 0 589 275 B1 ist eine Zuführeinrichtung bekannt die diesen Anforderungen gerecht wird. Moderne Bestückautomaten erreichen steigende Taktfrequenzen beim Abholen und Bestücken der Bauelemente. Wenn z.B. bei einem Revolverbestückkopf eine Mehrzahl der Saugpipetten mit gleichen Bauteilen zu belegen ist, müssen diese aus dem Gurt so schnell wie möglich nachgeführt werden, um der Abholleistung des Bestückkopfes nahe zu kommen.

Ferner ist durch die DE 37 10 310 A1 eine Zuführeinrichtung für Bauelemente bekannt geworden, bei der eine magnetisch betätigbare Klinke in eine Verzahnung einer Vorratsspule eingreift und diese jeweils für einen Vorschubtakt freigibt.

Der Erfindung liegt die Aufgabe zugrunde, das Nachziehen des Bauteilegurtes noch weiter zu beschleunigen.

Diese Aufgabe wird durch die Erfindung gemäß Anspruch 1 gelöst.

Durch den aktiven Anschlag kann nun die Lagefixierung des Antriebs unmittelbar im Vorwärtsgang realisiert werden, ohne daß dazu ein Umkehrung der Drehrichtung mit dem entsprechenden Zeitverlust erforderlich ist. Der Anschlag kann z.B. durch ein pneumatisches Stellement betätigt werden, wie es z.B. zum Öffnen und Schließen eines Abholfensters für die Bauelemente verwendet wird. Wird es mit diesem z.B. synchron betätigt, so bedarfs es dafür keines eigenen Steuerventils.

Eine Weiterbildung der Erfindung nach Anspruch 2 ermöglicht mit geringem Aufwand eine zuverlässige Realisierung des mechanischen Anschlags.

Ein Ausführungsbeispiel der Erfindung ist in der Zeichnung dargestellt und wird im folgenden näher beschrieben.

Es zeigen:
- Figur 1: das Grundprinzip einer Zuführeinrichtung für gegurtete Bauelemente in stark vereinfachter schematischer Darstellung,
- Figur 2: den mechanischen Anschlag des Antriebsmotors der in Figur 1 dargestellten Zuführeinrichtung und
- Figur 3: die Indexscheibe des Sensors zur Erfassung der Anzahl der Umdrehungen der Antriebsmotors des in Figur 1 dargestellten Zuführeinrichtung.

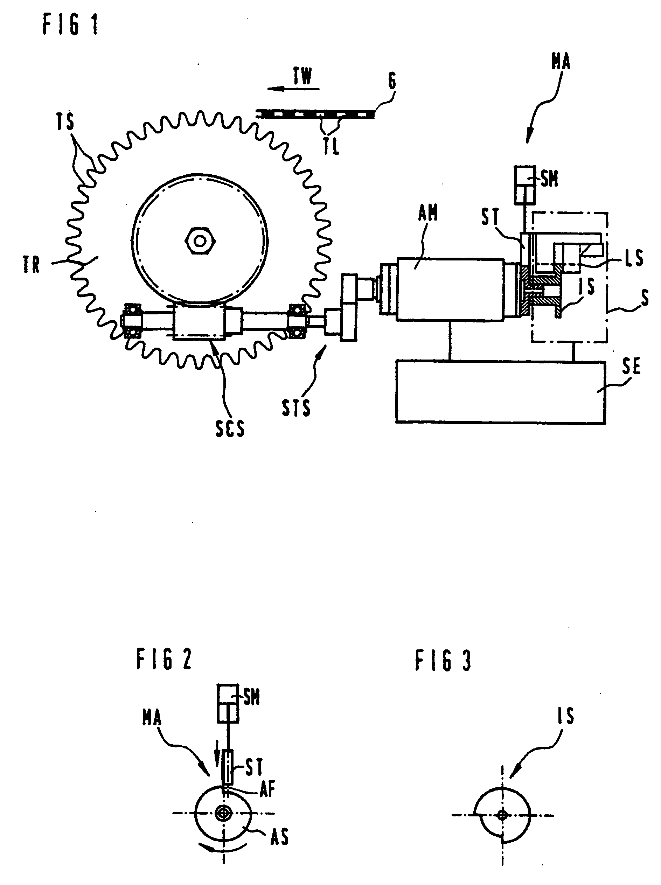

Figur 1 zeigt das Antriebsprinzip einer Zuführeinrichtung für gegurtete SMD-Bauelemente. Die Transportstifte TS eines Transportrades TR sind derart bemessen, daß sie für den schrittweisen Transport eines Gurtes G in dessen Transportlöcher TL eingreifen können. Im dargestellten Ausführungsbeispiel sind die Transportlöcher TL des Gurtes G in einem Teilungsabstand von 4 mm angeordnet.

Der Antrieb des Transportrades TR erfolgt über eine Stirnradstufe STS und eine Schneckenradstufe SCS, deren Übersetzunen derart gewählt sind, daß eine volle Umdrehung des Antriebsmotors AM einen Transportweg TW des Gurtes G von 2 mm bewirkt. Dies bedeutet mit anderen Worten, daß zwei Umdrehungen des Antriebsmotors AM eine Drehung des Transportrades TR um den Teilungsabstand der Transportstifte TS und somit einen Transportweg TW des Gurtes G bewirkt, der einem Teilungsabstand der Transportlöcher TL des Gurtes G von 4 mm entspricht.

Auf der der Stirnratstufe STS gegenüberliegenden Seite des Antriebsmotors AM sind auf dessen nicht näher bezeichneter Antriebswelle das Anschlagrad AS eines mechanischen Anschlags MA und die Indexscheibe IS eines Sensors S zur Erfassung der Anzahl der Umdrehungen des Antriebsmotors AM angeordnet. Der mechanische Anschlag MA, dessen Wirkungsweise insbesondere aus Figur 2 ersichtlich ist, umfaßt neben der Anschlagscheibe AS einen axial verschiebbaren Stift ST. Der Sensor S umfaßt neben der Indexscheibe IS eine damit zusammenwirkende Lichtschranke LS. Die Form der Indexscheibe IS ist aus der in Figur 3 gezeigten Draufsicht ersichtlich.

Die Steuerung des Antriebsmotors AM erfolgt über eine Steuereinrichtung SE, welche ihrerseits mit dem Sensor S verbunden ist.

Bei einer Rasterteilung der Bauelementefächer des Gurtes G von 2 mm wird nach der Entnahme eines SMD-Bauelements der Antriebsmotor AM eingeschaltet wobei der Stift ST aus dem Umfangsbereich der Anschlagscheibe AS hereusgezogen wird., Der Gurt G wird dabei analog zur Drehstellung des Motors transportiert. Jede vollständige Umdrehung wird vom Sensor S der Steuereinrichtung SE gemeldet. Nach der Vollendung vorletzten und vor Vollendung der letzte Umdrehung veranlaßt die Steuereinrichtungtung SE das Stellelement SM, den Stift ST in die Bewegungsbahn der Anschlagscheibe AS hineinzuschieben. Dadurch fährt eine Anschlagfläche AF mit Erreichen der nächsten vollen Umdrehung gegen den Stift ST, worauf die Steuereinrichtung SE ein Abschalten des Antriebsmotors bewirkt, indem der dem Antriebsmotor AM zugeführte Strom nach einer Exponentialfunktion gegen Null gefahren wird.
In dieser durch den mechanischen Anschlag MA definierten Position beträgt der Transportweg TW des Gurtes G exakt 2 mm und das nächste volle Bauelementefach befindet sich genau in der gewünschten Entnahmeposition.

Bei einer Rasterteilung der Bauelementefächer des Gurtes G von z.B. 4 mm wird nach der Entnahme eines SMD-Bauelementes der Antriebsmotor AM eingeschaltet und wieder abgebremst, sobald der Sensor S der Steuereinrichtung SE zwei vollständige Umdrehungen des Antriebsmotors AM meldet. Sobald die Anschlagscheibe AS die in Figur 2 darge-stellte Stellung der letzten vollen Umdrehung erreicht hat, greift der gefederte Stift ST ein und stoppt den An-triebsmotor AM, der unmittelbar danach abgeschaltet wird. In dieser durch den mechanischen Anschlag MA definierten Position beträgt der Transportweg TW des Gurtes G exakt 4 mm und das nächste volle Bauelementefach befindet sich genau in der gewünschten Entnahmeposition.

## Patentansprüche

1. Zuführeinrichtung für gegurtete SMD-Bauelemente, mit
- einem Transportrad (TR), dessen Transportstifte (TS) in die Transportlöcher (TL) des Gurtes (G) eingreifen,
- mindestens einem Antriebsmotor (AM), der das Transportrad (TR) derart antreibt, daß eine Umdrehung des Antriebsmotors (AM) einen Transportweg (TW) des Gurtes (G) bewirkt, der einer Teilung oder einem Bruchteil der Teilung der Bauelementefächer des Gurtes (G) entspricht,
- einem Sensor (S) zur Erfassung der Anzahl der Umdrehungen des Antriebsmotors (AM),
- einer mit dem Rotor des Antriebmotors verbundene, quer zu einer Tangentialrichtung stehenden Anschlagfläche,
- einem gegen die Anschlagfläche wirkenden mechanischen Anschlag (MA), der die Drehung des Antriebsmotors (AM) in der Stellung einer vollständigen Umdrehung des Antriebsmotors (AM) stoppt und
**dadurch gekennzeichnet,**
**daß** der mechanische Anschlag mittels eines aktiven Stellelements schaltbar ausgebildet ist, daß der Anschlag zu Beginn der Vorschubdrehung des Antriebsmotors von der Anschlagfläche abhebbbar ist und vor dem Ende der vollständigen Umdrehung in die Bewegungsbahn der Anschlagfläche hinschiebbar ist
und **daß** die Drehbewegung bis zum Erreichen der Anschlagstellung der Anschlagfläche fortsetzbar ist.

2. Zuführeinrichtung nach Anspruch 1,
**dadurch gekennzeichnet,**
**daß** der mechanische Anschlag (MA) durch einen tangential beweglichen Stift (ST) und die Anschlagfläche in einer Anschlagscheibe (AS) gebildet ist.

## Claims

1. Feed device for taped SMD components, having
- a transport wheel (TR) whose transport pins (TS) engage in the transport holes (TL) in the tape (G),
- at least one drive motor (AM), which drives the transport wheel (TR) in such a manner that one or more complete revolutions of the drive motor (AM) produce a transport movement (TW) of the tape (G) which corresponds to the pitch of the component compartments in the tape (G),
- a sensor (S) for detecting the number of revolutions of the drive motor (AM),
- a stop surface which is connected to the rotor of the drive motor and is positioned tranversely with respect to a tangential direction,
- a mechanical stop (MA) which acts against the stop surface and stops the rotation of the drive motor (AM) in the position corresponding to one complete revolution of the drive motor (AM), and
**characterized**
**in that** the mechanical stop is designed such that it can be switched by means of an active control element,
**in that** the stop can be lifted off the stop surface at the start of the feed rotation of the drive motor and can be pushed into the movement path of the stop surface before the end of that complete revolution, and
**in that** the rotary movement can be continued until the stop position of the stop surface is reached.

2. Feed device according to Claim 1,
**characterized**
**in that** the mechanical stop (MA) is formed by a tangentially moving pin (ST) and by the stop surface in a stop disc (AS).

## Revendications

1. Dispositif d'amenée pour composants (SMD) sur bande, qui comprend
une roue de transport (TR) dont les dents de transport (TS) s'engagent dans les perforations de transport (TL) de la bande (G),
au moins un moteur d'entraînement (AM) qui entraîne la roue de transport (TR) de telle sorte qu'un tour du moteur d'entraînement (AM) provoque un chemin de transport (TW) de la bande (G) qui correspond à un pas ou à une fraction du pas des compartiments de composants de la bande (G),
un détecteur (S) pour la saisie du nombre de tours du moteur d'entraînement (AM),
une surface de butée reliée au rotor du moteur d'entraînement et orientée transversalement par rapport à une direction tangentielle,
une butée mécanique (MA) agissant en opposition à la surface de butée qui arrête le mouvement rotatif du moteur d'entraînement (AM) dans la position d'un tour complet du moteur d'entraînement (AM),
**caractérisé en ce que** la butée mécanique est configurée de manière à pouvoir être ajustée à l'aide d'un composant actif de réglage, **en ce que** l'on peut retirer la butée de la surface de butée au début de la rotation d'avance du moteur d'entraînement, et que l'on peut placer cette butée dans le parcours de mouvement de la surface de butée avant la fin du tour complet et **en ce que** le mouvement rotatif peut être poursuivi jusqu'à l'atteinte de la position de butée de la surface de butée.

2. Dispositif d'amenée selon la revendication 1, **caractérisé en ce que** la butée mécanique (MA) est constituée d'une dent (ST) à déplacement tangentiel et de la surface de butée située dans un disque (AS) de butée.
